(19) Europäisches Patentamt
European Patent Office
Office européen des brevets

(11) **EP 2 169 823 B1**

(12) **EUROPEAN PATENT SPECIFICATION**

(45) Date of publication and mention
of the grant of the patent:
**04.05.2011  Bulletin 2011/18**

(51) Int Cl.:
*H03F 1/02* *(2006.01)*     *H03F 3/60* *(2006.01)*

(21) Application number: **08290904.5**

(22) Date of filing: **24.09.2008**

(54) **Combined multi-path high-efficiency power amplifier**

Kombinierter Mehrpfad-Leistungsverstärker mit hohem Wirkungsgrad

Amplificateur de puissance multivoies combiné à haut rendement

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**31.03.2010  Bulletin 2010/13**

(73) Proprietor: **Alcatel Lucent**
**75008 Paris (FR)**

(72) Inventor: **Grebennikov, Andrei**
**Casleknock, Dublin 15 (IE)**

(74) Representative: **Narmon, Gisèle Marie Thérèse et al**
**Alcatel-Lucent Bell NV**
**Copernicuslaan 50**
**2018 Antwerpen (BE)**

(56) References cited:
**WO-A-97/24800     DE-A1-102005 058 039**
**US-A- 5 793 253**

• **ANDREI GREBENNIKOV ET AL: "High-efficiency balanced switched-path monolithic SiGe HBT power amplifiers for wireless applications" MICROWAVE INTEGRATED CIRCUIT CONFERENCE, 20007. EUMIC 2007. EUROPEAN, IEEE, PI, 1 October 2007 (2007-10-01), pages 391-394, XP031197697 ISBN: 978-2-87487-002-6**

**Description**

The present invention relates to a power amplifier structure having, between a main input and a main output, a circuit architecture comprising a first quadrature hybrid of which a first terminal is connected to said main input and a second quadrature hybrid of which a first terminal is connected to said main output, the circuit architecture of said power amplifier structure comprising a balanced pair of high power paths, a first high power path comprising a first high power amplifier structure having a power input coupled to a second terminal of said first quadrature hybrid and a power output coupled to a second terminal of said second quadrature hybrid, and a second high power path comprising a second high power amplifier structure having a power input coupled to a third terminal of said first quadrature hybrid and a power output coupled to a third terminal of said second quadrature hybrid, the circuit architecture of said power amplifier structure also comprising a low power amplifying path constituted by a low power amplifier having an input connected to a fourth terminal of said first quadrature hybrid and an output connected to a fourth terminal of said second quadrature hybrid.

In most communication systems it is required that the power amplifier structure could operate with high efficiency and high linearity simultaneously. However, there is a tradeoff between efficiency and linearity with improvement in one coming at the expense of another. Besides, many wireless communications systems, such as Global System for Mobile communications/ Enhanced Data rates for GSM Evolution GSM/EDGE, Code-Division Multiple-Access CDMA2000 or Wide-band Code-Division Multiple-Access W-CDMA require that the power amplifier could deliver a wide range of output powers. As a result, being designed for the highest power level with maximum available efficiency, the power amplifier both in base stations and handsets tends to operate less efficiently at lower power levels consuming a lot of extra dc power. In addition, it is very important to keep a high linearity at high output power with variation of the load impedance.

The article "High Efficiency Balanced Switched-Path Monolithic SiGe HBT Power Amplifiers for Wireless Applications" of A. Grebennikov et al. published in the Proc. 37th Europ. Microwave Conf., pp. 1189-1192, 2007, discloses such a highly efficient power amplifier structure having high efficiency at different output power levels. Therein, each high power amplifier structure of the balanced pair of high power paths is constituted by a single high power amplifier.

This known power amplifier structure incorporates an additional separate low power amplifying path connected between the fourth terminals or isolated ports of the first quadrature hybrid that is a 90-degree input hybrid power divider or input quadrature hybrid power divider, and the second quadrature hybrid that is a 90-degree output hybrid power combiner or output quadrature hybrid power combiner.

In a high power mode, the output powers from both balanced high power paths (bias is turned on) combine in the output hybrid power combiner and the low power path is isolated from them (bias is turned off), thus providing high efficiency at high output power. As an example, when all ports are matched for a hybrid branch-line combiner, power entering first terminal, i.e. main input, is divided between the second and third terminals with a 90-degree phase shift between these terminals and no power is delivered to the fourth terminal or isolated port. A quadrature hybrid has an important advantage compared to in-phase dividers that at equal values of reflection coefficients from loads connected to the second and thrid terminals, the reflection wave is lacking at the first or input terminal and, consequently, input Voltage Standing Wave Ratio VSWR of a quadrature hybrid does not depend on the equal load mismatch level. In this case, all reflected power is dissipated in 50-Ohm ballast resistor connected to the fourth terminal or isolated port. As a result, the isolated port of the input hybrid becomes the input for a low power amplifying path when bias for high power amplifying paths are turned off, while the isolated port of the output hybrid works as its output 50-Ohm port. Hence, the high efficiency at lower output power levels can be achieved and no need to include additional power switches to isolate high power balanced paths and low power path.

However, in this configuration, the maximum efficiency can be achieved at two output power levels only (maximum and one backoff level, for example, ideally 3-dB backoff power if all power amplifiers have similar structure). Another prior art power amplifier structure is given by document DE 10 2005 058039 A1.

An object of the present invention is to provide a power amplifier structure of the above known type but which can provide multiple peak efficiencies at different backoff powers.

According to the invention, this object is achieved due to the fact that the internal circuit architecture of said first high power path and the internal circuit architecture of said second high power path are both identical to the circuit architecture of said power amplifier structure.

In this way, each high power amplifier structure of the balanced pair of high power paths is no longer constituted by a single high power amplifier but is now advantageously replaced by a more complex structure similar to that of the power amplifier structure itself. This circuit architecture allows obtaining the maximum efficiency at more than two output power levels.

In more detail, the present invention is characterized in that said first high power path has an internal circuit architecture comprising a third quadrature hybrid of which a first terminal is connected to the power input of said first high power path and a fourth quadrature hybrid of which a first terminal is connected to the power output of said first high power path,

the internal circuit architecture of said first high power path further comprising a balanced pair of internal high power paths, a first internal high power path comprising a first high power amplifier having an amplifier input connected to a second terminal of said third quadrature hybrid and an amplifier output connected to a second terminal of said fourth quadrature hybrid, and a second internal high power path comprising a second high power amplifier having an amplifier input connected to a third terminal of said third quadrature hybrid and an amplifier output connected to a third terminal of said fourth quadrature hybrid,

the internal circuit architecture of said first high power path also comprising an internal low power amplifying path constituted by a second low power amplifier having an input connected to a fourth terminal of said third quadrature hybrid and an output connected to a fourth terminal of said fourth quadrature hybrid,

and in that said second high power path has an internal circuit architecture comprising a fifth quadrature hybrid of which a first terminal is connected to the power input of said second high power path and a sixth quadrature hybrid of which a first terminal is connected to the power output of said second high power path,

the internal circuit architecture of said second high power path further comprising a balanced pair of internal high power paths, a first internal high power path comprising a third high power amplifier having an amplifier input connected to a second terminal of said fifth quadrature hybrid and an amplifier output connected to a second terminal of said sixth quadrature hybrid, and a second internal high power path comprising a fourth high power amplifier having an amplifier input connected to a third terminal of said fifth quadrature hybrid and an amplifier output connected to a third terminal of said sixth quadrature hybrid, the internal circuit architecture of said second high power path also comprising an internal low power amplifying path constituted by a third low power amplifier having an input connected to a fourth terminal of said fifth quadrature hybrid and an output connected to a fourth terminal of said sixth quadrature hybrid.

In this way, significantly higher efficiency is obtained for the same linearity at different backoff output powers without need in additional switching or linearization technique.

Another characterizing feature of the present invention is that the circuit architecture of each of the internal high power paths is identical to the circuit architecture of said power amplifier structure.

In this way, each internal high power path inside another high power path, of a higher level, has a circuit architecture similar to that of the power amplifier structure itself. In other words, a kind of nested power amplifier structures is created to achieve the maximum efficiency at even more output power levels.

The present power amplifier structure provides high efficiency for RF power amplifiers at different levels of backoff output powers depending on the number of amplifying paths only. There is no need to use additional lossy switches at the output of the power amplifier to switch amplifying paths with different output powers unlike in a conventional case. In addition, there is no need to use DPD (digital predistorter) to linearize power amplifier at the backoff output powers compared to inherently nonlinear Doherty technique.

This highly efficient multi-path power amplifier structure can thus provide multiple peak efficiencies at different backoff powers. For example, n (n = 2, 3, ...) levels of the output powers with peak efficiencies beginning from maximum can be obtained with 2m + 1 power amplifiers, where m is the number of power amplifiers for previous number of levels, for example, m = 3 for n = 2 levels, m = 7 for n = 3 levels, m = 15 for n = 4 levels,

.... It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:

Fig. 1 represents a power amplifier structure as known from the prior art;
Fig. 2 is a block schematic of a quadrature hybrid used in the present power amplifier structure;
Fig. 3 represents a power amplifier structure according to the invention; and
Fig. 4 shows the overall dependence of the efficiency versus output power of the present power amplifier structure.

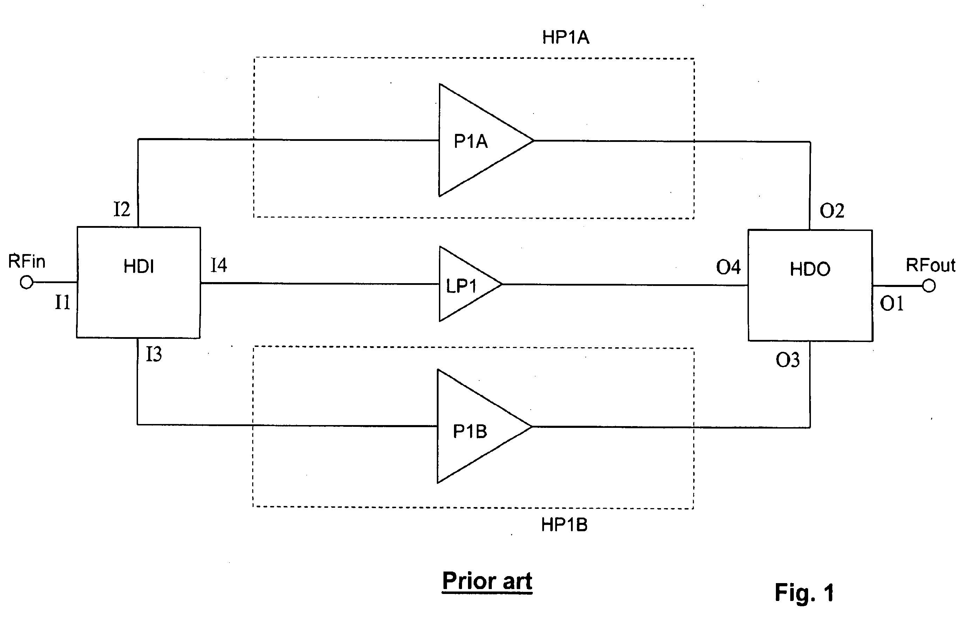

The power amplifier structure shown at Fig. 1 is known from the prior art and is used in wireless communications systems, such as Global System for Mobile communications/ Enhanced Data rates for GSM Evolution GSM/EDGE, Code-Division Multiple-Access CDMA2000 or Wide-band Code-Division Multiple-Access W-CDMA to deliver a wide range of output powers with high efficiency and high linearity simultaneously.

To this end, the known power amplifier structure includes, between a main Radio Frequency input RFin and a main Radio Frequency output RFout, a circuit architecture comprising an input quadrature hybrid power divider HDI of which a first terminal I1 is connected to the main input RFin and an output quadrature hybrid power combiner HDO of which a first terminal O1 is connected to the main output RFout.

The circuit architecture of the known power amplifier structure further comprises a balanced pair of high power paths HP1A, HP1B of which:

- a first high power path HP1A comprises a first high power amplifier structure having a power input coupled to a second terminal I2 of the input quadrature hybrid power divider HDI and a power output coupled to a second terminal 02 of the output quadrature hybrid power combiner HDO, and
- the second high power path HP1B comprises a second high power amplifier structure having a power input coupled to a third terminal I3 of input quadrature hybrid power divider HDI and a power output coupled to a third terminal 03 of said second quadrature hybrid power combiner HDO.

The circuit architecture of the known power amplifier structure is completed with a low power amplifying path constituted by a low power amplifier LP1 having an input connected to a fourth terminal I4 of the input quadrature hybrid power divider HDI and an output connected to a fourth terminal 04 of the input quadrature hybrid power combiner HDO.

Therein, each high power amplifier structure of the balanced pair of high power paths HP1A and HP1B is constituted by a single high power amplifier P1A and P1B respectively.

In this known power amplifier structure, each quadrature hybrid is, for instance, as known from the document "Quadrature Hybrids 90° Power Dividers/ Combiners 10 KHz To 40 GHz General Information" available on the Internet at

< www.merrimacind.com/rfmw/05intro_quadhybrids.pdf >

Therein is mentioned that the 90° Power Dividers/Combiners are four port networks capable of operating from 10 kHz to 40 GHz and available in a wide variety of package options. These devices can perform two complementary functions:

a) Power Divider: One function is to equally divide an input signal into two output signals while imparting to one of the outputs a 90° phase shift with respect to the phase of the other output. Thus, the outputs exhibit a quadrature relationship meaning their respective phases differ by one "quadrant" or simply 90°; and

b) Power Combiner: The complementary function is to combine two equal amplitude, quadrature-phased input signals into a single output signal.

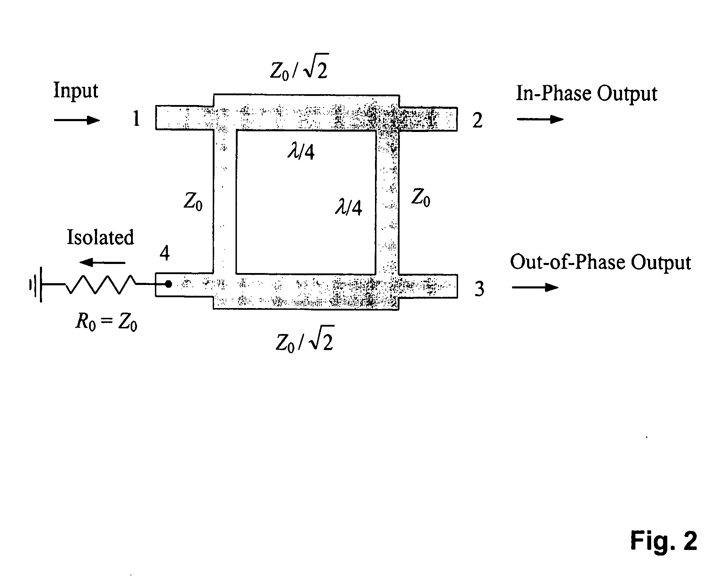

As an example, when all ports are matched for a hybrid branch-line combiner as shown at Fig. 2, the power entering input port 1 referred above as first terminal O1, is divided between the output port 2 that is an in-phase port or In-Phase Output referred above as second terminal 02, and port 3 that is a 90° phase shift port or Out-of-Phase Output referred above as third terminal 03, with a 90° phase shift between these outputs 2 and 3, and no power is delivered to the Isolated port 4 referred above as fourth terminal 04.

The quadrature hybrid can generally be implemented with any lumped or quarter-wavelength $\lambda/4$ transmission-line elements. A first quarter-wavelength $\lambda/4$ transmission line having a characteristic impedance

$$Zo \quad /\sqrt{2}$$ is connected between the ports 1 and 2. A second quarter-wavelength $\lambda/4$ transmission line also having a characteristic impedance $$Zo \quad /\sqrt{2}$$ is connected between the ports 4 and 3. A third quarter-wavelength $\lambda/4$ transmission line having characteristic impedance Zo is connected between the ports 1 and 4. A fourth quarter-wavelength $\lambda/4$ transmission line also having characteristic impedance Zo is connected between the ports 2 and 3

In the above example, all reflected power is dissipated in 50 $\Omega$ ballast resistor Ro = Zo connected to the isolated port 4.

Although this known power amplifier structure is adapted to achieve high efficiency at lower output power levels without the need of additional power switches to isolate high power balanced paths and low power path, the maximum efficiency can be achieved at two output power levels only (maximum and one backoff level, for example, ideally 3-dB backoff power if all power amplifiers have similar structure).

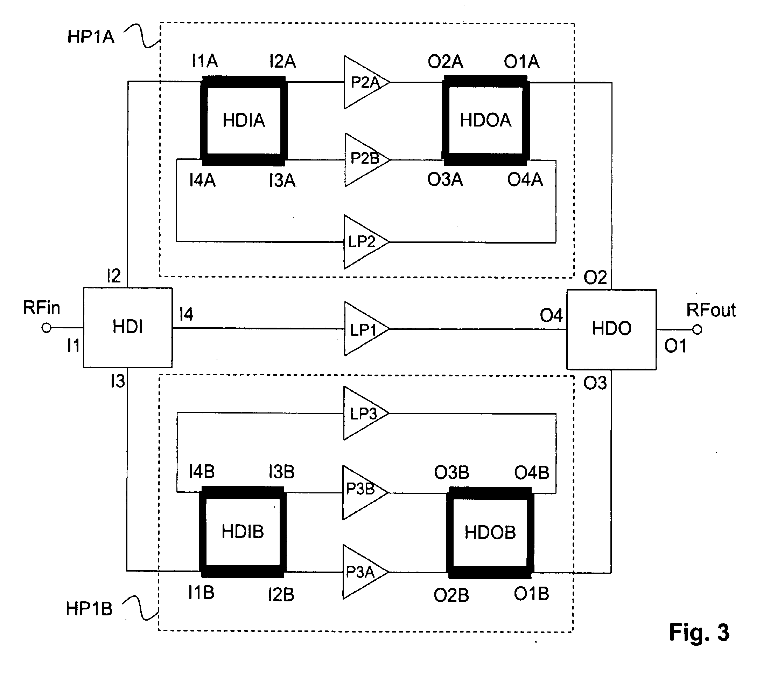

The architecture proposed by the present invention and shown at Fig. 3 is a highly efficient multi-path power amplifier that can provide multiple peak efficiencies at different backoff powers.

In the present power amplifier structure, each high power path HP1A and HP1B is no longer a conventional single-stage high power amplifier P1A and P1B as at Fig. 1, but is replaced by a circuit of which the architecture is similar to that of the power amplifier structure itself.

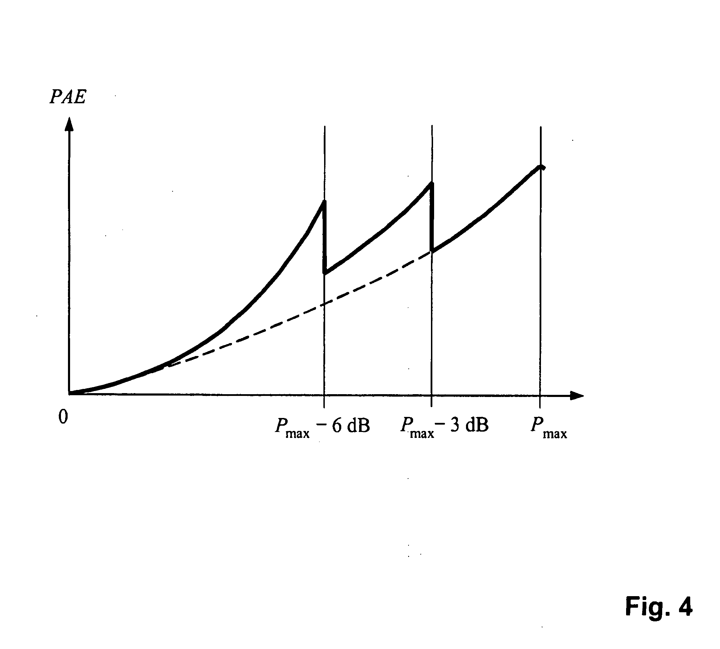

In more detail, Fig. 3 shows a power amplifier structure with seven power amplifiers P2A, P2B, LP2, LP1, LP3, P3B and P3A which can provide peak efficiencies at three powers levels, as shown at Fig. 4.

The present power amplifier structure has a main Radio Frequency input RFin connected to a first terminal I1 of an input quadrature hybrid power divider HDI and a main Radio Frequency output RFout connected to a first terminal O1 of an output quadrature hybrid power combiner HDO.

The power amplifier structure comprises a low power amplifying path constituted by a single low power amplifier LP1 having an input connected to a fourth terminal I4 of the input quadrature hybrid power divider HDI and an output connected to a fourth terminal 04 of the input quadrature hybrid power combiner HDO.

The power amplifier structure further comprises a balanced pair of high power paths HP1A and HP1B of which:

- a first high power path HP1A has a first high power amplifier structure with a power input coupled to a second terminal I2 of the input quadrature hybrid power divider HDI and a power output coupled to a second terminal 02 of the output quadrature hybrid power combiner HDO, and
- the second high power path HP1B has a second high power amplifier structure with a power input coupled to a third terminal I3 of input quadrature hybrid power divider HDI and a power output coupled to a third terminal 03 of said second quadrature hybrid power combiner HDO.

The internal circuit architecture of the first high power path HP1A includes a second input quadrature hybrid power divider HDIA, a second output quadrature hybrid power combiner HDOA, a balanced pair of two internal high power paths P2A and P2B, and an internal low power amplifier LP2, whilst the internal circuit architecture of the second high power path HP1B includes a third input quadrature hybrid power divider HDIB, a third output quadrature hybrid power combiner HDOB, a balanced pair of two internal high power paths P3A and P3B, and an internal low power amplifier LP3.

In more detail, the power input of the first high power path HP1A is connected to a first terminal I1A of the second input quadrature hybrid power divider HDIA and a first terminal O1A of the second output quadrature hybrid power combiner HDOA is connected to the power output of the first high power path HP1A.

A first internal high power path of the balanced pair of the first high power path HP1A comprises a first high power amplifier P2A having an amplifier input connected to a second terminal I2A of the second input quadrature hybrid power divider HDIA and an amplifier output connected to a second terminal O2A of the second output quadrature hybrid power combiner HDOA, whilst the second internal high power path of this balanced pair comprises a second high power amplifier P2B having an amplifier input connected to a third terminal I3A of the second input quadrature hybrid power divider HDIA and an amplifier output connected to a third terminal O3A of the second output quadrature hybrid power combiner HDOA.

The internal circuit architecture of the first high power path HP1A further comprises a low power amplifying path constituted by the internal low power amplifier LP2 having an input connected to a fourth terminal I4A of the second input quadrature hybrid power divider HDIA and an output connected to a fourth terminal O4A of the second output quadrature hybrid power combiner HDOA.

Similarly, the power input of the second high power path HP1B is connected to a first terminal I1B of the third input quadrature hybrid power divider HDIB and a first terminal O1B of the third output quadrature hybrid power combiner HDOB is connected to the power output of this second high power path HP1B.

A first internal high power path of the balanced pair of the second high power path HP1B comprises a first high power amplifier P3A having an amplifier input connected to a second terminal I2B of the third input quadrature hybrid power divider HDIB and an amplifier output connected to a second terminal O2B of the third output quadrature hybrid power combiner HDOB, whilst the second internal high power path of this balanced pair comprises a second high power amplifier P3B having an amplifier input connected to a third terminal I3B of the third input quadrature hybrid power divider HDIB and an amplifier output connected to a third terminal O3B of the third output quadrature hybrid power combiner HDOB.

The internal circuit architecture of the second high power path HP1B further comprises a low power amplifying path constituted by the internal low power amplifier LP3 having an input connected to a fourth terminal I4B of the third input quadrature hybrid power divider HDIB and an output connected to a fourth terminal O4B of the third output quadrature hybrid power combiner HDOB.

Owing to the three input hybrid quadrature dividers HDI, HDIA, HDIB and three output hybrid quadrature combiners HDO, HDOA, HDOB used in this power amplifier structure, the following is achieved:

- Maximum power at maximum efficiency is realized when power amplifiers P2A, P2B and P3B, P3A are switched on (bias is turned on), and the others LP2, LP1, LP3 connected to the isolated ports of quadrature hybrids are switched off (bias is turned off);
- The maximum efficiency at 3 dB backoff power is achieved when power amplifiers P2A, P2B, LP1, P3B, P3A are switched off, and power amplifiers LP2 and LP3 connected to the isolated ports of top and bottom quadrature hybrids, respectively, are biased on; and
- Finally, maximum efficiency at 6 dB backoff power can be obtained when the only power amplifier LP1 connected between the isolated ports of input and output quadrature couplers is switched on, and the other power amplifiers P2A, P2B, LP2, LP3, P3B, P3A are switched off.

The overall dependence of the efficiency versus output power (solid line with three peaks) is shown at Fig. 4, where also the efficiency of the conventional power amplifier is shown (dashed line). In addition, the presence of the output quadrature hybrid power combiners or quadrature hybrid couplers HDOA and HDOB at the output can improve the linearity performance over different values of the load Voltage Standing Wave Ratio VSWR compared to the conventional single-stage power amplifier P1A and P1B at Fig. 1. This is because each of the two amplifiers in a balanced power amplifier pair sees opposite impedances (high impedance and low impedance) because of 90-degree phase shift between their outputs. Since the linear requirements remain for low impedance with some increase in the output power, the only half an output signal has worse linearity performance compared to a conventional case where this is a concern for a total output signal. As already mentioned above, each quadrature hybrid can generally be implemented with any lumped or transmission-line elements.

The principle of the present invention can be further set out by creating a kind of "nested" power amplifier structures whereby each single high power amplifier of each high power path can be again replaced by a more complex circuit of which the architecture is again similar to that of the power amplifier structure itself. This allows achieving the maximum efficiency at even more output power levels. For example, n (n = 2, 3, ...) levels of the output powers with peak efficiencies beginning from maximum can be obtained with 2m + 1 power amplifiers, where m is the number of power amplifiers for previous number of levels, for example, m = 3 for n = 2 levels, m = 7 for n = 3 levels, m = 15 for n = 4 levels, ....

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

**Claims**

1. A power amplifier structure having, between a main input (RFin) and a main output (RFout), a circuit architecture comprising a first quadrature hybrid (HDI) of which a first terminal (I1) is connected to said main input and a second quadrature hybrid (HDO) of which a first terminal (O1) is connected to said main output,
   the circuit architecture of said power amplifier structure comprising a balanced pair of high power paths (HP1A, HP1B), a first high power path (HP1A) comprising a first high power amplifier structure having a power input coupled to a second terminal (I2) of said first quadrature hybrid (HDI) and a power output coupled to a second terminal (02) of said second quadrature hybrid (HDO), and a second high power path (HP1B) comprising a second high power amplifier structure having a power input coupled to a third terminal (I3) of said first quadrature hybrid (HDI) and a power output coupled to a third terminal (03) of said second quadrature hybrid (HDO),
   the circuit architecture of said power amplifier structure also comprising a low power amplifying path constituted by a low power amplifier (LP1) having an input connected to a fourth terminal (I4) of said first quadrature hybrid (HDI) and an output connected to a fourth terminal (04) of said second quadrature hybrid (HDO),
   *characterized in that* the internal circuit architecture of said first high power path (HP1A) and the internal circuit architecture of said second high power path (HP1B) are both identical to the circuit architecture of said power amplifier structure.

2. The power amplifier structure according to claim 1, *characterized in that* said first high power path (HP1A) has an internal circuit architecture comprising a third quadrature hybrid (HDIA) of which a first terminal (I1A) is connected to the power input of said first high power path and a fourth quadrature hybrid (HDOA) of which a first terminal (O1A) is connected to the power output of said first high power path,
   the internal circuit architecture of said first high power path (HP1A) further comprising a balanced pair of internal high power paths, a first internal high power path comprising a first high power amplifier (P2A) having an amplifier input connected to a second terminal (I2A) of said third quadrature hybrid (HDIA) and an amplifier output connected to a second terminal (O2A) of said fourth quadrature hybrid (HDOA), and a second internal high power path comprising a second high power amplifier (P2B) having an amplifier input connected to a third terminal (I3A) of said third quadrature hybrid (HDIA) and an amplifier output connected to a third terminal (O3A) of said fourth quadrature hybrid (HDOA),
   the internal circuit architecture of said first high power path (HP1A) also comprising an internal low power amplifying path constituted by a second low power amplifier (LP2) having an input connected to a fourth terminal (I4A) of said third quadrature hybrid (HDIA) and an output connected to a fourth terminal (O4A) of said fourth quadrature hybrid (HDOA).

3. The power amplifier structure according to any of the claims 1 or 2, *characterized in that* said second high power path (HP1B) has an internal circuit architecture comprising a fifth quadrature hybrid (HDIB) of which a first terminal (I1B) is connected to the power input of said second high power path and a sixth quadrature hybrid (HDOB) of which a first terminal (O1B) is connected to the power output of said second high power path,

the internal circuit architecture of said second high power path (HP1B) further comprising a balanced pair of internal high power paths, a first internal high power path comprising a third high power amplifier (P3A) having an amplifier input connected to a second terminal (I2B) of said fifth quadrature hybrid (HDIB) and an amplifier output connected to a second terminal (O2B) of said sixth quadrature hybrid (HDOB), and a second internal high power path comprising a fourth high power amplifier (P3B) having an amplifier input connected to a third terminal (I3B) of said fifth quadrature hybrid (HDIB) and an amplifier output connected to a third terminal (O3B) of said sixth quadrature hybrid (HDOB),

the internal circuit architecture of said second high power path (HP1B) also comprising an internal low power amplifying path constituted by a third low power amplifier (LP3) having an input connected to a fourth terminal (I4B) of said fifth quadrature hybrid (HDIB) and an output connected to a fourth terminal (O4B) of said sixth quadrature hybrid (HDOA).

4. The power amplifier structure according to any of the previous claims, *characterized in that* the circuit architecture of each of the internal high power paths (P2A, P2B, P3A, P3B) is identical to the circuit architecture of said power amplifier structure.

5. The power amplifier structure according to any of the previous claims, *characterized in that* said quadrature hybrid is a four port network of which the first terminal is an input port, the second terminal is an In-Phase Output port, the third terminal is an Out-of-Phase Output port, with a 90° phase shift between the second and the third terminals, and the fourth terminal is an isolated port.

6. The power amplifier structure according to claim 5, *characterized in that* said first (HDI), third (HDIA) and fifth (HDIB) quadrature hybrids are input quadrature hybrid power dividers,
*and in that* said second (HDO), fourth (HDOA) and sixth (HDOB) quadrature hybrids are output quadrature hybrid power combiners.

**Patentansprüche**

1. Leistungsverstärkerstruktur, welche zwischen einem Haupteingang (RFin) und einem Hauptausgang (RFout) eine Schaltungsarchitektur aufweist, die einen ersten Quadratur-Hybrid (HDI) mit einem ersten Anschluss (I1), der an den besagten Haupteingang gekoppelt ist, und einen zweiten Quadratur-Hybrid (HDO) mit einem ersten Anschluss (O1), der an den besagten Hauptausgang gekoppelt ist, umfasst, wobei die Schaltungsarchitektur der besagten Leistungsverstärkerstruktur ein symmetrisches Paar von Hochleistungspfaden (HP1A, HP1B) aufweist, wobei ein erster Hochleistungspfad (HP1A) eine erste Hochleistungsverstärkerstruktur mit einem an einen zweiten Anschluss (I2) des besagten ersten Quadratur-Hybrids (HDI) gekoppelten Leistungseingang und einem an einen zweiten Anschluss (02) des besagten zweiten Quadratur-Hybrids (HDO) gekoppelten Leistungsausgang umfasst, und wobei ein zweiter Hochleistungspfad (HP1B) eine zweite Hochleistungsverstärkerstruktur mit einem an einen dritten Anschluss (I3) des besagten ersten Quadratur-Hybrids (HDI) gekoppelten Leistungseingang und einem an einen dritten Anschluss (03) des besagten zweiten Quadratur-Hybrids (HDO) gekoppelten Leistungsausgang umfasst,

wobei die Schaltungsarchitektur der besagten Leistungsverstärkerstruktur ebenfalls einen Niederleistungsverstärkungspfad umfasst, welcher aus einem Niederleistungsverstärker (LP1) mit einem an einen vierten Anschluss (I4) des besagten ersten Quadratur-Hybrids (HDI) gekoppelten Eingang und einem an einen vierten Anschluss (04) des besagten zweiten Quadratur-Hybrids (HDO) gekoppelten Ausgang besteht,

*dadurch gekennzeichnet, dass* die interne Schaltungsarchitektur des besagten ersten Hochleistungspfads (HP1A) und die interne Schaltungsarchitektur des besagten zweiten Hochleistungspfads (HP1B) beide mit der Schaltungsarchitektur der besagten Leistungsverstärkerstruktur identisch sind.

2. Die Leistungsverstärkerstruktur nach Anspruch 1, *dadurch gekennzeichnet, dass* der besagte erste Hochleistungspfad (HP1A) eine interne Schaltungsarchitektur aufweist, welche einen dritten Quadratur-Hybrid (HDIA) mit einem ersten Anschluss (I1A), der an den Leistungseingang des besagten ersten Hochleistungspfads gekoppelt ist, und einen vierten Quadratur-Hybrid (HDOA) mit einem ersten Anschluss (O1A), der an den Leistungsausgang des besagten ersten Hochleistungspfads gekoppelt ist, umfasst,

wobei die interne Schaltungsarchitektur des besagten ersten Hochleistungspfads (HP1A) weiterhin ein symmetrisches Paar von internen Hochleistungspfaden mit einem ersten internen Hochleistungspfad, welcher einen ersten Hochleistungsverstärker (P2A) mit einem an einen zweiten Anschluss (I2A) des besagten dritten Quadratur-Hybrids (HDIA) gekoppelten Verstärkereingang und einem an einen zweiten Anschluss (02A) des besagten vierten Quadratur-Hybrids (HDOA) gekoppelten Verstärkerausgang umfasst, und einem zweiten internen Hochleistungspfad, welcher einen zweiten Hochleistungsverstärker (P2B) mit einem an einen dritten Anschluss (I3A) des besagten dritten Quadratur-Hybrids (HDIA) gekoppelten Verstärkereingang und einem an einen dritten Anschluss (03A) des besagten vierten Quadratur-Hybrids (HDOA) gekoppelten Verstärkerausgang umfasst, aufweist,

wobei die interne Schaltungsarchitektur des besagten ersten Hochleistungspfads (HP1A) ebenfalls einen internen Niederleistungsverstärkungspfad bestehend aus einem zweiten Niederleistungsverstärker (LP2) mit einem an einen vierten Anschluss (I4A) des besagten dritten Quadratur-Hybrids (HDIA) gekoppelten Eingang und einem an einen vierten Anschluss (04A) des besagten vierten Quadratur-Hybrids (HDOA) gekoppelten Ausgang umfasst.

3. Die Leistungsverstärkerstruktur nach einem beliebigen der Ansprüche 1 oder 2, *dadurch gekennzeichnet, dass* der besagte zweite Hochleistungspfad (HP1B) eine interne Schaltungsarchitektur mit einem fünften Quadratur-Hybrid (HDIB), dessen erster Anschluss (I1B) an den Leistungseingang des besagten zweiten Hochleistungspfads gekoppelt ist, und mit einem sechsten Quadratur-Hybrid (HDOB), dessen erster Anschluss (O1B) an den Leistungsausgang des besagten zweiten Hochleistungspfads gekoppelt ist, aufweist,

wobei die interne Schaltungsarchitektur des besagten zweiten Hochleistungspfads (HP1B) weiterhin ein symmetrisches Paar von internen Hochleistungspfaden aufweist, wobei ein erster interner Hochleistungspfad einen dritten Hochleistungsverstärker (P3A) mit einem an einen zweiten Anschluss (I2B) des besagten fünften Quadratur-Hybrids (HDIB) gekoppelten Verstärkereingang und einem an einen zweiten Anschluss (02B) des besagten sechsten Quadratur-Hybrids (HDOB) gekoppelten Verstärkerausgang umfasst, und ein zweiter interner Hochleistungspfad einen vierten Hochleistungsverstärker (P3B) mit einem an einen dritten Anschluss (I3B) des besagten fünften Quadratur-Hybrids (HDIB) gekoppelten Verstärkereingang und einem an einen dritten Anschluss (03B) des besagten sechsten Quadratur-Hybrids (HDOB) gekoppelten Verstärkerausgang umfasst,

wobei die interne Schaltungsarchitektur des besagten zweiten Hochleistungspfads (HP1B) weiterhin einen internen Niederleistungsverstärkungspfad bestehend aus einem dritten Niederleistungsverstärker (LP3) mit einem an einen vierten Anschluss (I4B) des besagten fünften Quadratur-Hybrids (HDIB) gekoppelten Eingang und einem an einen vierten Anschluss (04B) des besagten sechsten Quadratur-Hybrids (HDOA) gekoppelten Ausgang umfasst.

4. Die Leistungsverstärkerstruktur nach einem beliebigen der vorstehenden Ansprüche, *dadurch gekennzeichnet, dass* die Schaltungsarchitektur eines jeden der internen Hochleistungspfade (P2A, P2B, P3A, P3B) mit der Schaltungsarchitektur der besagten Leistungsverstärkerstruktur identisch ist.

5. Die Leistungsverstärkerstruktur nach einem beliebigen der vorstehenden Ansprüche, *dadurch gekennzeichnet, dass* der besagte Quadratur-Hybrid ein Vier-Port-Netzwerk ist, wobei der erste Anschluss ein Eingangsport, der zweite Anschluss ein phasengleicher Ausgangsport, der dritte Anschluss ein phasenverschobener Ausgangsport mit einer Phasenverschiebung von 90° zwischen dem zweiten und dem dritten Anschluss, und der vierte Anschluss ein isolierter Port ist.

6. Die Leistungsverstärkerstruktur nach Anspruch 5, *dadurch gekennzeichnet, dass* der besagte erste (HDI), der besagte dritte (HDIA) und der besagte fünfte (HDIB) Quadratur-Hybrid Quadratur-Hybrid-Eingangsleistungsteiler sind,

*und dass* der besagte zweite (HDO), der besagte vierte (HDOA) und der besagte sechste (HDOB) Quadratur-Hybrid Quadratur-Hybrid-Ausgangsleistungszusammenführer sind.

## Revendications

1. Structure d'amplificateur de puissance comprenant, entre une entrée principale (RFin) et une sortie principale (RFout), une architecture de circuit comprenant un premier hybride à quadrature (HDI) dont une première borne (I1) est connectée à ladite entrée principale et un deuxième hybride à quadrature (HDO) dont une première borne (O1) est connectée à ladite sortie principale,

l'architecture de circuit de ladite structure d'amplificateur de puissance comprenant une paire équilibrée de chemins de grande puissance (HP1A, HP1B), un premier chemin de grande puissance (HP1A) comprenant une première structure d'amplificateur de grande puissance dont une entrée de puissance est connectée à une deuxième borne (I2) dudit premier hybride à quadrature (HDI) et une sortie de puissance connectée à une deuxième borne (02) dudit deuxième hybride à quadrature (HDO) et un deuxième chemin de grande puissance (HP1B) comprenant une deuxième structure d'amplificateur de grande puissance dont une entrée de puissance est connectée à une troisième borne (I3) dudit premier hybride à quadrature (HDI) et une sortie de puissance connectée à une troisième borne (03) dudit deuxième hybride à quadrature (HDO),

l'architecture de circuit de ladite structure d'amplificateur de puissance comprenant également un chemin de basse puissance composé d'un amplificateur de basse puissance (LP1) dont une entrée est connectée à une quatrième borne (I4) dudit premier hybride à quadrature (HDI) et une sortie est connectée à une quatrième borne (04) dudit deuxième hybride à quadrature (HDO),

*caractérisée en ce que* l'architecture de circuit interne dudit premier chemin de grande puissance (HP1A) et l'architecture de circuit interne dudit deuxième chemin de grande puissance (HP1 B) sont toutes deux identiques à l'architecture de circuit de ladite structure d'amplificateur de puissance.

2. Structure d'amplificateur de puissance selon la revendication 1, *caractérisée en ce que* ledit premier chemin de grande puissance (HP1A) possède une architecture de circuit interne comprenant un troisième hybride à quadrature (HDIA) dont une première borne (I1A) est connectée à l'entrée de puissance dudit premier chemin de grande puissance et un quatrième hybride à quadrature (HDOA) dont une première borne (01A) est connectée à la sortie de puissance dudit premier chemin de grande puissance,

l'architecture de circuit interne dudit premier chemin de grande puissance (HP1A) comprenant en outre une paire équilibrée de chemins de grande puissance internes, un premier chemin de grande puissance interne comprenant un premier amplificateur de grande puissance (P2A) dont une entrée d'amplificateur est connectée à une deuxième borne (I2A) dudit troisième hybride à quadrature (HDIA) et une sortie d'amplificateur est connectée à une deuxième borne (02A) dudit quatrième hybride à quadrature (HDOA), et un deuxième chemin de grande puissance interne comprenant un deuxième amplificateur de grande puissance (P2B) dont une entrée d'amplificateur est connectée à une troisième borne (I3A) dudit troisième hybride à quadrature (HDIA) et une sortie d'amplificateur est connectée à une troisième borne (O3A) dudit quatrième hybride à quadrature (HDOA),

l'architecture de circuit interne dudit premier chemin de grande puissance (HP1A) comprenant également un chemin d'amplification interne de basse puissance composé d'un deuxième amplificateur de basse puissance (LP2) dont une entrée est connectée à une quatrième borne (I4A) dudit troisième hybride à quadrature (HDIA) et une sortie est connectée à une quatrième borne (04A) dudit quatrième hybride à quadrature (HDOA).

3. Structure d'amplificateur de puissance selon l'une quelconque des revendications 1 ou 2, *caractérisée en ce que* ledit deuxième chemin de grande puissance (HP1B) possède une architecture de circuit interne comprenant un cinquième hybride à quadrature (HDIB) dont une première borne (I1B) est connectée à l'entrée de puissance dudit deuxième chemin de grande puissance et un sixième hybride à quadrature (HDOB) dont une première borne (O1 B) est connectée à la sortie de puissance dudit deuxième chemin de grande puissance,

l'architecture de circuit interne dudit deuxième chemin de grande puissance (HP1B) comprenant en outre une paire équilibrée de chemins de grande puissance internes, un premier chemin de grande puissance interne comprenant un troisième amplificateur de grande puissance (P3A) dont une entrée d'amplificateur est connectée à une deuxième borne (I2B) dudit cinquième hybride à quadrature (HDIB) et une sortie d'amplificateur est connectée à une deuxième borne (02B) dudit sixième hybride à quadrature (HDOB), et un deuxième chemin de grande puissance interne comprenant un quatrième amplificateur de grande puissance (P3B) dont une entrée d'amplificateur est connectée à une troisième borne (I3B) dudit cinquième hybride à quadrature (HDIB) et une sortie d'amplificateur est connectée à une troisième borne (03B) dudit sixième hybride à quadrature (HDOB),

l'architecture de circuit interne dudit deuxième chemin de grande puissance (HP1B) comprenant également un chemin d'amplification interne de basse puissance composé d'un troisième amplificateur de basse puissance (LP3) dont une entrée est connectée à une quatrième borne (I4B) dudit cinquième hybride à quadrature (HDIB) et une sortie est connectée à une quatrième borne (04B) dudit sixième hybride à quadrature (HDOB).

4. Structure d'amplificateur de puissance selon l'une quelconque des revendications précédentes, *caractérisée en ce que* l'architecture de circuit de chacun des chemins de grande puissance internes (P2A, P2B, P3A, P3B) est identique à l'architecture de circuit de ladite structure d'amplificateur de puissance.

5. Structure d'amplificateur de puissance selon l'une quelconque des revendications précédentes, *caractérisée en ce que* ledit hybride à quadrature est un réseau à quatre ports dont la première borne est un port d'entrée, la deuxième borne est un port de sortie en phase, la troisième borne est un port de sortie déphasée, avec un déphasage de 90 ° entre la deuxième et la troisième bornes, et la quatrième borne est un port isolé.

6. Structure d'amplificateur de puissance selon la revendication 5,
*caractérisée en ce que* lesdits premier (HDI), troisième (HDIA) et cinquième (HDIB) hybrides à quadrature sont des diviseurs de puissance hybrides à quadrature,

et *en ce que* lesdits deuxième (HDO), quatrième (HDOA) et sixième (HDOB) hybrides à quadrature sont des combineurs de puissance hybrides à quadrature.

HP1A

P1A

I2

RFin O
I1    HDI    I4    LP1    O4    HDO    O1  O RFout

I3

P1B

HP1B

**Prior art**          **Fig. 1**

EP 2 169 823 B1

Fig. 2

Fig. 3

EP 2 169 823 B1

**Fig. 4**

**EP 2 169 823 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• DE 102005058039 A1

**Non-patent literature cited in the description**

• **A. Grebennikov et al.** High Efficiency Balanced Switched-Path Monolithic SiGe HBT Power Amplifiers for Wireless Applications. *Proc. 37th Europ. Microwave Conf.,* 2007, 1189-1192